Europäisches Patentamt

(19) European Patent Office

Office européen des brevets

(11) Publication number: **0 131 055**
**B1**

# (12) EUROPEAN PATENT SPECIFICATION

(45) Date of publication of the patent specification:
**29.10.86**

(51) Int. Cl.⁴: **H 04 L  27/08, H 03 G  3/20**

(21) Application number: **84900671.3**

(22) Date of filing: **09.01.84**

(86) International application number:
**PCT/US 84/00022**

(87) International publication number:
**WO  84/02818  (19.07.84 Gazette 84/17)**

(54) **AUTOMATIC GAIN CONTROL CIRCUIT.**

(30) Priority: **12.01.83  GB 8300696**
        **30.06.83  US 509280**

(43) Date of publication of application:
**16.01.85 Bulletin 85/3**

(45) Publication of the grant of the patent:
**29.10.86 Bulletin 86/44**

(84) Designated Contracting States:
**DE FR**

(56) References cited:
**DE - A - 1 902 661**
**DE - B - 2 844 291**
**GB - A - 1 217 491**
**GB - A - 2 026 269**
**GB - A - 2 034 139**

(73) Proprietor: **NCR Corporation, World Headquarters,
Dayton, Ohio 45479 (US)**

(72) Inventor: **VAN DRIEST, Hans, Ptolomeusplein 95,
NL-Bilthoven (NL)**

(74) Representative: **Robinson, Robert George, International
Patent Department NCR Limited 206 Marylebone Road,
London NW1 6LY (GB)**

## Description

*Technical Field*

This invention relates to an automatic gain control circuit including variable gain amplifying means adapted to amplify an input signal, control signal generator means adapted to generate a control signal for controlling the gain of said variable gain amplifying means, and level detection means coupled to an output of said variable gain amplifying means and to an input of said control signal generator means, wherein said level detection means is adapted to provide a first or a second logic signal to said control signal generator means according to whether the output signal of said variable gain amplifying means is greater or less than a predetermined level, said first and second logic signals causing said control signal generator means to vary said control signal in respective first and second directions so as to respectively reduce and increase the gain of said variable gain of said variable gain amplifying means.

*Background Art*

A particular application of automatic gain control circuits of the kind specified is in a data modem receiver utilized in a digital data transmission system wherein the data is transmitted in the form of a modulated carier wave as an analog signal over a transmission medium such as a telephone line. As is well known the imperfect characteristic of the analog transmission medium cause the signal received at the remote receiver to differ from that transmitted, since the signal may be corrupted by various impairments during transmission. In some types of modulation, such as quadrature amplitude modulation (QAM), the amplitude of the received signal is of particular significance. One type of impairment which affects the amplitude of the signal is known as a gain hit and is a sudden change in signal level. Such an impairment may be compensated for by providing an automatic gain control circuit at the input to the modem receiver. Such automatic gain control circuit should have a wide dynamic range in order to provide effective compensation where the unimpaired received signal may vary over a large range, such as about 40 decibels (dB), depending on the losses experienced in the transmission channel. The automatic gain control circuit should provide a reliable signal level prior to any analog-to-digital conversion which may take place in a modem wherein the received signal is processed digitally.

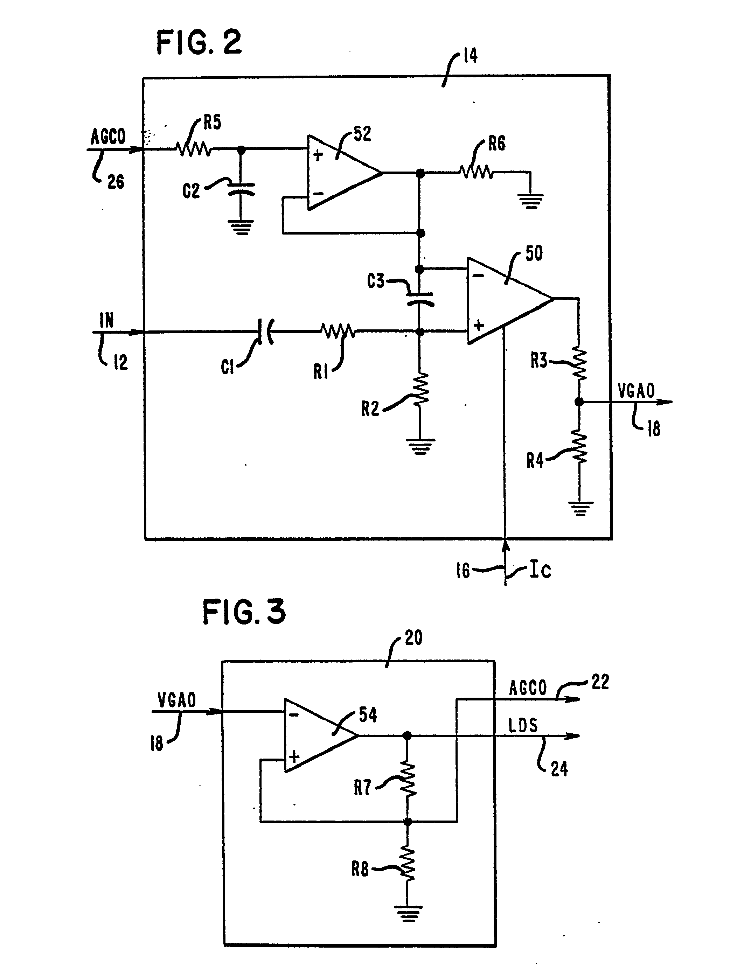

An automatic gain control circuit of the kind specified is known from the article «A review of automatic gain control theory» by D. V. Mercy, published by Institution of Electronic and Radio Engineers, 99 Gower Street, London WC1, England, in The Radio and Electronic Engineer, vol. 51, No. 11/12, December 1981, pages 579/590. See especially Fig. 2 on page 580.

The known automatic gain control circuit has the disavantage that the incidence of impulse noise in the transmission may adversely affect the performance of the automatic gain control circuit. Thus, the circuit gain may change considerably in response to a noise pulse in view of such a noise pulse typically having a large amplitude. Since the automatic gain control circuit cannot respond to signal level changes instantaneously, the output signal of the gain control circuit in the period shortly after termination of a noise pulse is likely to be at an unsuitable level for further processing whereby errors may arise.

Various suggestions have been made with a view to reducing the sensitivity of automatic gain control circuits to noise impulses.

One suggested approach involves amplitude detection or limitation. For example GB-A-2 026 269 discloses an automatic gain control (AGC) circuit suitable for a video IF amplifier, including a voltage controlled amplifier, an AGC detector and an AGC time constant circuit which form an AGC loop. The AGC circuit further includes a level detector and a time constant designator. When the level detector detects an excess level at the output of the voltage controlled amplifier, e.g. due to pulse noise, the time constant designator increases the time constant of the AGC time constant circuit. Other disclosures of this general approach are found in DE-B-2 844 291 and DE-A-1 902 661.

An alternative approach is to provide for rapid recovery (decay). Thus, GB-A-1 217 491 discloses an AGC system including two gain control generator circuits connected in parallel, one having a rapid rise time and a short hang time (that is, the time during which the AGC signal continues to be generated at the original level after a reduction in the mean signal level), and the other having a relatively long rise time and a hang time controllable in dependence upon an input signal applied to the system, wherein only the first AGC circuit is responsive to transient noise burst and wherein control of the hang time of the second circuit enables the system to provide a control voltage which follows fading input signals. Another disclosure of this general approach is contained in GB-A-2 034 139.

*Disclosure of the Invention*

According to the present invention, there is provided an automatic gain control circuit of the kind specified, characterized by protection means coupled to said level detection means and adapted whenever said first logic signal is provided for longer than a first predetermined time period to cause said control signal generator means to prevent said control signal from varying in said first direction for a second predetermined time period, thereby inhibiting any reduction in gain of said variable gain amplifying means during said second predetermined time period.

It will be appreciated that in an automatic gain control circuit according to the invention this protection means permits only a limited response to a gain change. Thus, by selecting the second predetermined time period to be greater than the duration of a typical noise pulse, the circuit response to such noise pulse is limited despite such noise pulse possibly being of a high amplitude level.

*Brief Description of the Drawings*

One embodiment of the invention will now be described by way of example with reference to the accompanying drawings, in which:

Fig. 1 is a block diagram of an automatic gain control circuit according to the invention;

Fig. 2 is a circuit diagram of a variable gain amplifier included in the circuit of Fig. 1;

Fig. 3 is a circuit diagram of an output amplifier included in the circuit of Fig. 1;

Fig. 4 is a circuit diagram of a level detector included in the circuit of Fig. 1;

Fig. 5 is a circuit diagramm of an attacky/decay control circuit included in the circuit of Fig. 1;

Fig. 6 is a circuit diagram of a noise hit protection circuit included in the circuit of Fig. 1;

Fig. 7 is a circuit diagram of a control current generator included in the circuit of Fig. 1;

Fig. 8 is a graphical representation of the behavior of two circuit parameters with respect to time during an attack operation in the circuit of Fig. 1;

Fig. 9 is a graphical representation of the behavior of two circuit parameters with respect to time during a decay operation in the circuit of Fig. 1;

Fig. 10 is a time plot illustrating the no-signal to signal behavior of the circuit of Fig. 1;

Fig. 11 is a time plot illustrating the signal to no-signal behavior of the circuit of Fig. 1;

Fig. 12 is a time plot illustrating the gain hit behavior of the circuit of Fig. 1 with the noise hit protection circuit inactive;

Fig. 13 is a time plot illustrating the gain hit behaviour of the circuit of Fig. 1 with the noise hit protection circuit active;

Fig. 14 is a time plot illustrating the noise hit behavior of the circuit of Fig. 1 with the noise hit protection circuit inactive; and

Fig. 15 is a time plot illustrating the noise hit behavior of the circuit of Fig. 1 with the noise hit protection circuit active.

*Best Mode for Carrying Out the Invention*

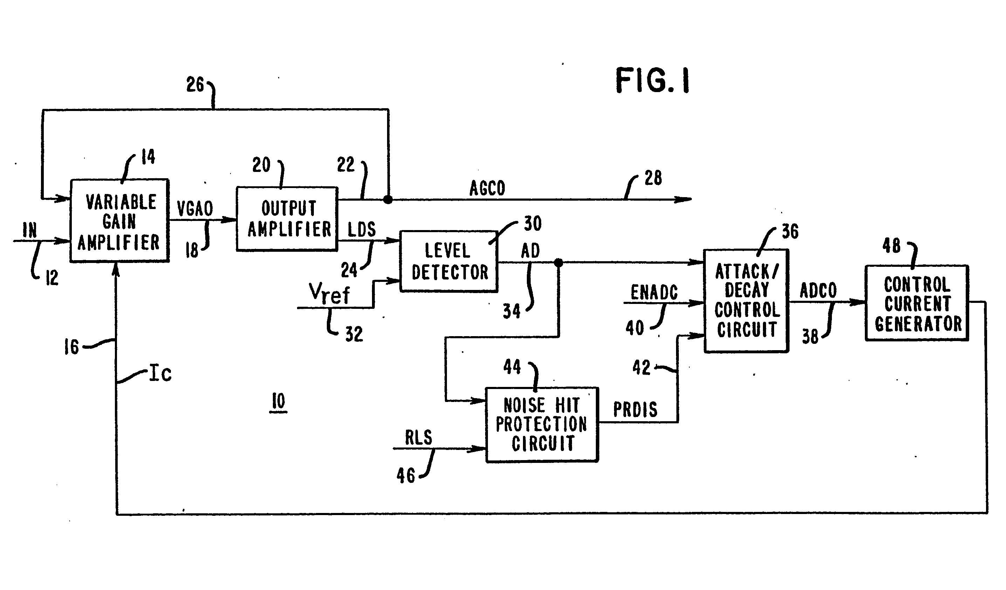

Referring first to Fig. 1, there is shown an automatic gain control circuit 10 suitable for use in a receiver section of a modem (not shown) which is utilized in a digital data transmission system wherein the data is transmitted in quadrature amplitude modulation (QAM) form. The gain control circuit 10 will first be described generally with reference to the blocks shown in Fig. 1, whereafter a more detailed description of the individual blocks will be presented. The received signal is applied over a line 12 to a variable gain amplifier 14 which amplifies the input signals by a factor determined by a control current $I_c$ on a lead 16.

The gain controlled output signal VGAO of the variable gain amplifier 14 is applied over a line 18 to an output amplifier 20 which provides an output signal AGCO on a line 22 which represents the signal VGAO and an output signal LDS on a line 24 which represents a predetermined multiple of the signal VGAO. The signal LDS is a buffered (low impedance) analog signal having in the present embodiment an amplitude 11 times the amplitude of the signal VGAO. The output signal AGCO is fed back over a line 26 to an input of the variable gain amplifier 14 and is applied over a line 28 for processing in the modem receiver (not shown).

The signal LDS on the line 24 is applied to a level detector 30 to which is applied a reference potential $V_{ref}$ over a line 32. In the present embodiment $V_{ref}$ has a value of $+5V$. The level detector 30 detects and compares the level of the signal LDS with the reference potential $V_{ref}$. An output signal AD on a line 34 is at a high logic level or a low logic level according as the level of the signal LDS is greater or less than the reference potential $V_{ref}$.

The line 34 is coupled to an attack/decay control circuit 36 which provides, on a line 38, an output signal ADCO containing control information. The attack/deckay control circuit 36 receives as inputs: the signal AD on the line 34; a signal ENADC on a line 40 from a microprocessor (not shown) in the modem receiver; and a signal PRDIS on a line 42 provided by a noise hit protection circuit 44. The level of the signal AD determines whether an attack operation (reduction in gain of the variable gain amplifier 14) or a decay operation (increase in gain of the variable gain amplifier 14) is to take place. Thus a high level for the signal AD produces an attack operation whereas a low level for the signal AD produces a decay operation. The ENADC signal has a selected one of two levels. According as the signal ENADC has a high or a low level, the decay speed is slow or high respectively. The signal PRDIS is effective, when an attack operation is taking place, to abort the attack operation and to force a decay operation for a predetermined time. The output signal ADCO is either at ground level or at a $-5V$ level or is an open circuit.

The noise hit protection circuit 44 monitors the signal AD. If the signal AD is high, signifiying an attack operation, for greater than a predetermined time, which is selected as 50 microseconds in the present embodiment, the circuit 44 will cause the output signal PRDIS to be high thereby aborting the attack operation as discussed hereinabove. Operation of the noise hit protection circuit 44 is disabled in response to a signal RLS on a line 46, provided by the aforementioned microprocessor in the modem receiver. Thus if the signal RLS has a low level, the noise hit protection circuit 44 is disabled. If the signal RLS has a high level the noise hit protection circuit 44 is enabled.

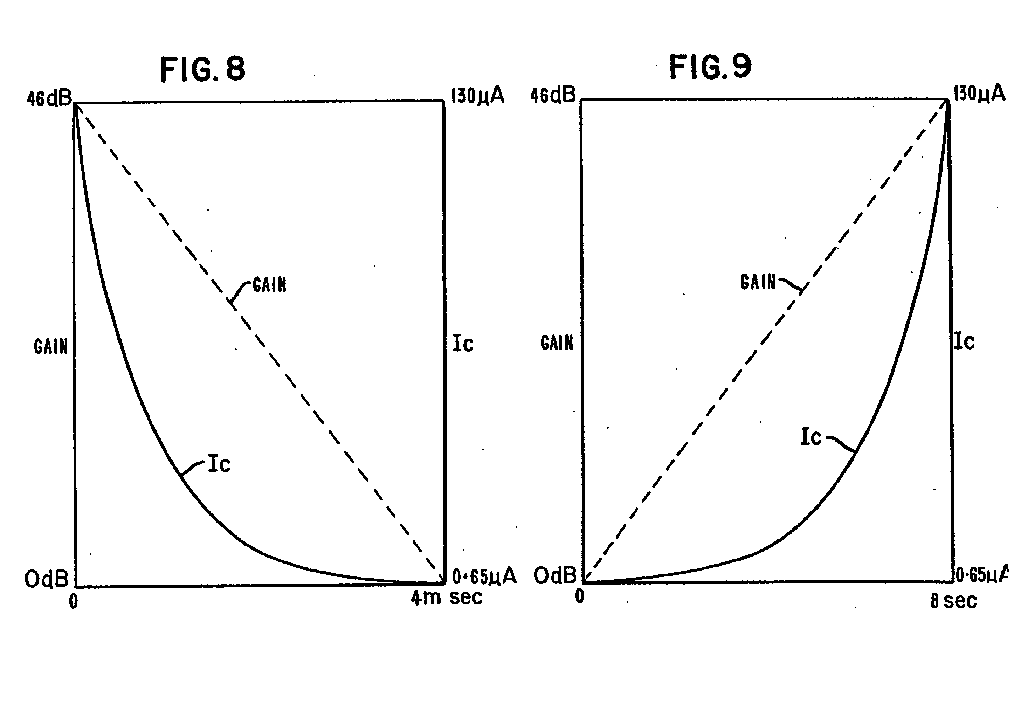

The lead 38 is coupled to a control current generator 48 which, in dependence on the signal ADCO, provides, on the line 16, the control current $I_c$ for the variable gain amplifier 14. The control current $I_c$ decreases in a negative exponential manner for an attack operation as shown in Fig. 8 and increases in a positive exponential mannert as shown in Fig. 9 for a decay operation. It will be appreciated that this exponential variation in the control current $I_c$ provides attack and decay speeds which are independent of the level of the received signal. The gain actually produced in the variable gain amplifier 14 is shown by the dashed lines in Figs. 8 and 9. If the signal ADCO from the attack/decay control circuit 36 is at ground level, the control current $I_c$ decreases, corresponding to an attack operation. If the signal ADCO is at the $-5V$ level the control current $I_c$ increases rapidly, corresponding to a fast decay operation. If the signal ADCO is open circuit (i.e. high impedance) the control current $I_c$ increases slowly, corresponding to a slow decay operation.

The variable gain amplifier 14 will now be described in detail with reference to Fig. 2. The input signal on the lead 12 is applied to a 0.68 microfarad ($\mu$F) decoupling capacitor C1 and is attenuated by resistors R1 and R2, the attenuated signal being applied to the non-inverting input of an operational transconductance amplifier 50 which may be an operational transconductance amplifier having the part number CA3080 manufactured by RCA Corporation. The resistors R1 and R2 have the values 3.48 kilohms (Kohm) and 100 ohms respectively. It should be understood that the transconductance of the operational transconductance amplifier 50 is directly proportional to the control current $I_c$. The amplifier 50 has resistors R3, R4 coupled in series to its output. The 1 megohm (Mohm) resistor R4, in conjunction with the control current $I_c$, determines the gain of the amplifier 50. The 220 Kohm resistor R3 limits the peak-to-peak amplitude of the output signal VGAO on the lead 18 to meet the requirements of the output amplifier 20.

Connected to the inverting input of the operational transconductance amplifier 50 is an operational amplifier 52 which has unity gain. The operational amplifier 52 may be a device having the part number TLO84A manufactured by Texas Instruments Inc. The signal AGCO on the line from the output amplifier 20 is applied to an RC filter formed by a 1.5 Mohm resistor R5 and a 0.68 $\mu$F capacitor C2, thereby attenuating AC frequency components usually present in the received line signal. The output of the RC filter formed by the resistor R5 and the capacitor C2 is coupled to the non-inverting input of the operational amplifier 52. The output of the operational amplifier 52 is coupled to the inverting input of the operational trancsonductance amplifier 50. Ths arrangement is effective to compensate for the d.c. offset voltage in the amplifier 50, the operational amplifier 52 and the output amplifier 20. A 51.1 ohm resistor R6 limits the maximum output voltage of the operational amplifier 52 to protect the input of the operational transconductance amplifier 50 and serves to decrease the input impedance of the amplifier 50 for highfrequency noise signals. A 0.1 $\mu$F capacitor C3 connected across the inverting and non-inverting inputs of the amplifier 50 serves to attenuate highfrequency noise signals.

Turning to Fig. 3, there is shown a detailed circuit diagram of the output amplifier 20. The signal VGAO on the line 18 is applied to the inverting input of an operational amplifier 54, which may be a Texas Instruments TLO84A device, and which serves to prevent the AGCO signal from loading. Resistors R7, R8 coupled to the output of the operational amplifier 54 determine the signal LDS as being a multiple of 11 times the signal VGAO. The resistor R7 has a value of 1 Kohm and the resistor R8 has a value of 100 ohms. The signal AGCO, produced on the line 22, is a voltage-follower output of the amplifier 54 and is equal to the signal VGAO multiplied by unity. The output signal AGCO provides the automatic gain control circuit output on the line 28 (Fig. 1) and is also fed back to the variable gain amplifier 14 for d.c. offset compensation as has been described hereinabove.

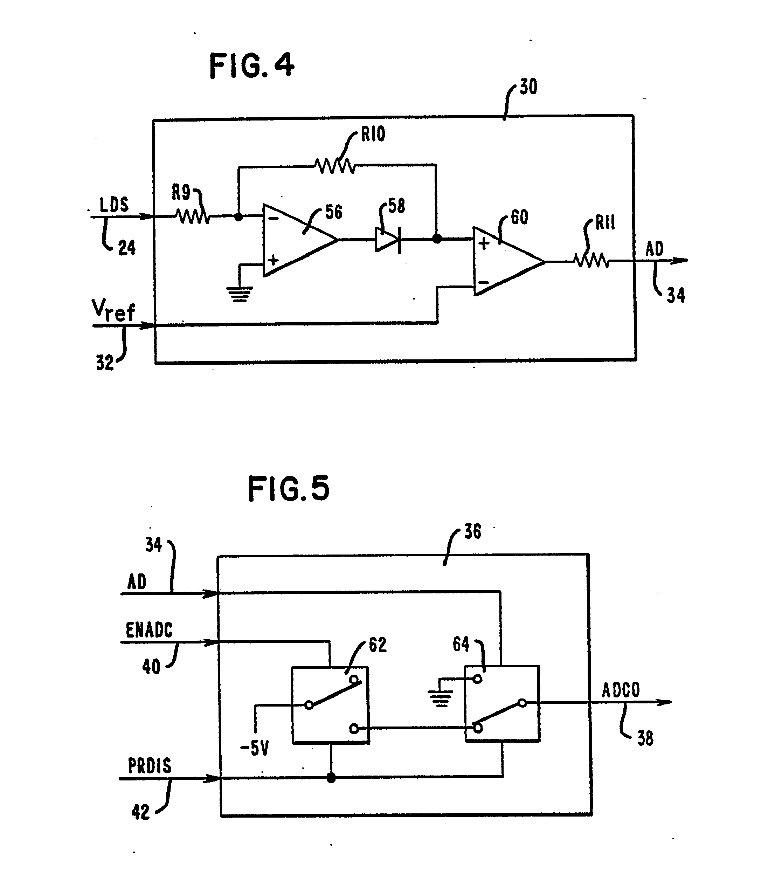

Referring to Fig. 4, the level detector 30 shown therein performs full-wave rectification and voltage comparison. The input signal LDS on the line 24 is applied through a 10 Kohm resistor R9 to the inverting input of an operational amplifier 56 which may be a Texas Instruments TLO84A device. The output of the operational amplifier 56 is coupled via a diode 58 to the non-inverting input of an operational amplifier 60 which may be a Texas Instruments TLO84A device. The inverting input of the amplifier 56 is coupled to the non-inverting input of the amplifier 60 through a 10 Kohm resistor R10. When the signal LDS is negative the amplifier 56 delivers a positive output which is applied to the non-inverting input of the amplifier 60. When the signal LDS is positive the output of the amplifier 56 is blocked by the diode 58. Since the non-inverting input of the amplifier 60 presents a very high impedance to the rectified signal, no current flows through the resistors R9, R10 and hence the level of the signal at the non-inverting input of the amplifier 60 is equal to LDS. The amplifier 60 is utilized as a comparator, its inverting input being coupled to a +5V reference source, $V_{ref}$ on line 32 such that when the input signal is greater than the reference voltage the output is at a high logic level and is at a low logic level when the input signal is less than the reference voltage. The output of the amplifier 60 is connected to a 10 Kohm resistor R11 to provide a suitable level for the output signal AD on the lead 34.

Referring to Fig. 5, the attack/decay control circuit 36 is formed by an analog switch device including a pair of analog switches 62, 64, and can be implemented by an analog multiplexer/demultiplexer device having the part number MC 14053B manufactured by Motorola Inc. The switches 62, 64 are responsive to the signals AD, ENADC and PRDIS to provide an output signal ADCO on the lead 38 in accordance with the following TABLE which in the final column identifies the nature of the automatic gain control operation performed in accordance with the value of the signal ADCO:

TABLE

| Condition | PRDIS | ENADC | AD | Output ADCO | Function |
|---|---|---|---|---|---|
| 1 | High | X | X | O/C | Slow decay |
| 2 | Low | High | Low | O/C | Slow decay |
| 3 | Low | X | High | GND | Attack |
| 4 | Low | Low | Low | —5V | Fast decay |

It will be appreciated that the switch 62 is shown for the input logic condition ENADC = 1 (high level) and the switch 64 is shown for the input logic conditions AD = 0 (low level). The signal PRDIS causes both switches to assume an intermediate, open-circuit (floating) state.

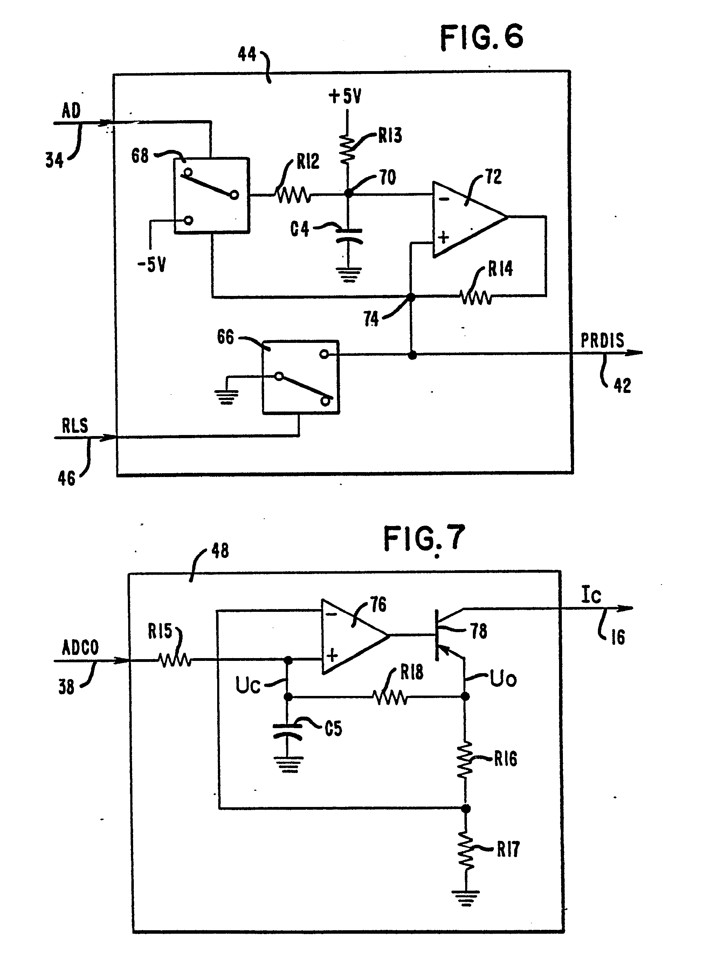

Referring to Fig. 6, there is shown a circuit diagram of the noise hit protection circuit 44. The input line 46 is coupled to a control input of a switch 66 arranged to selectively connect the output line 42 to ground. The circuit 44 is disabled by a low logic level signal RLS on the line 46 and is enabled by a high logic level signal RLS, which operates the switch 66 to the position shown in Fig. 6. The input lead 34 is coupled to a control input of a switch 68. The output of the switch 68 is connected over a 511 ohm resistor R12 to a junction point 70 to which is coupled a 0.1 µF capacitor C4. The junction point 70 is coupled through a 42.2 Kohm resistor R13 to a + 5V supply voltage source and to the inverting input of an operational amplifier 72 which may be a Texas Instruments TLO84A device. The output of the amplifier 72 is coupled via a 10 Kohm resistor R14 to a junction point 74. The junction point 74 is coupled to the output line 42, to the non-inverting input of the amplifier 72, to a further control input of the switch 68, and to the output of the switch 66.

When the signal AD is high the switch 68 connects a —5V supply voltage source to the resistor R12 thereby providing a discharge path for the capacitor C4. If the signal AD becomes low the switch 68 is operated to the position shown in Fig. 6. If the signal AD remains high for at least a predetermined time corresponding to a decrease in gain of 0.5 dB, the voltage et the inverting input of the operational amplifier 72 falls below that at its non-inverting input and the signal PRDIS becomes high. This causes the switch 68 to disconnect from the —5V supply potential and to open-circuit the switch 68 output. Thus the capacitor C4 commences to charge through the resistor R13. After approximately 10 ms the voltage across the capacitor C4 rises to a level which exceeds that of PRDIS and hence the operational amplifier 72 is effective to cause the signal PRDIS to become low again. The low state value of the signal PRDIS is approximately —0.7V and is determined by the resistor R14 and the input characteristic of the switches 62, 64 (Fig. 5) to which is signal PRDIS applied. The switch 68 can be A Motorola analog multiplexer/demultiplexer switch device having the part number MC14053B.

Referring now to Fig. 7 there is shown a circuit diagram for the control current generator 48. The input line 38 is coupled via a 3.48 Kohm resistor R15 to the non-inverting input of an operational amplifier 76 which may be a device having the part number TLO84A manufactured by Texas Instruments Inc. The non-inventing input of the amplifier 76 is coupled to a capacitor C5. The output of the amplifier 76 is connected to the base of a PNP transistor 78. The emitter of the transistor 78 is coupled through series-connected resistors R16 and R17, each having a value of 38.3 Kohm, to ground and is also coupled via a 6.8 Mohm resistor R18 to the non-inverting input of the amplifier 76. The collector of the transistor 78 is connected to the output line 16 on which the control current $I_c$ is provided. The circuit parameters are such that the voltage $U_o$ at the emitter of the transistor 78 is twice the voltage $U_c$ across the capacitor C5 at the non-inverting input of the amplifier 76.

The value of the control current $I_c$ is approximately proportional to $U_o$ as can be seen from the following equation:

$$I_c = \frac{U_o}{R16+R17} - I_b \approx \frac{U_o}{R16+R17} \qquad ---(1)$$

since $I_b$, the base current in the transistor 78, is sufficiently small to be neglected.

When the signal ADCO is at a logic low level (ground), the capacitor C5 discharges through the resistor R15 in a negative exponential manner. This produces an attack speed in decibels which is independent of $U_c$. The output current $I_c(t)$ is given by the following equation:

$$I_c(t) = -\frac{U_c\,(t=0)}{R17} \exp\,(-t/R15 \cdot C5) \qquad ---(2)$$

In this equation $U_c\,(t=0)$ represents the (negative) voltage across the capacitor C5 at the start of the discharge $(t=0)$. $I_c$ decreases exponentially as clearly seen from equation (2) and as is illustrated in Fig. 8 wherein the solid line represents a plot of the control current $I_c$ against time and the dashed line reprsents the corresponding gain.

When the input signal ADCO is open-circuit (floating) corresponding to a slow decay operation, the capacitor C5 charges through the resistor R18. It will be appreciated that with the configuration shown in Fig. 7 a higher voltage across the capacitor C5 results in a higher charge current and that an exponentially increasing control current $I_c$ is provided, as is illustrated in Fig. 9 wherein the solid line represents a plot of the control current $I_c$ against time. This behaviour is evident from the following equation (3):

$$I_c(t) = -\frac{U_c\,(t=0)}{R17} \exp\,(t.R16/R18 \cdot R17 \cdot C5)$$

$$---(3)$$

It will be appreciated that since $I_c$ increases exponentially a decay speed in decibels is provided which is independent of $U_c$.

When the input signal ADCO is at a —5V level the capacitor C5 charges through the resistor R15 and a fast decay operation is produced. Under these conditions $I_c$ increases in accordance with the following equation (4):

$$I_c(t) = -\frac{U_c\,(t=0)+5}{R17} \exp\,(-t/R15 \cdot C5) + \frac{5}{R17}$$

$$---(4)$$

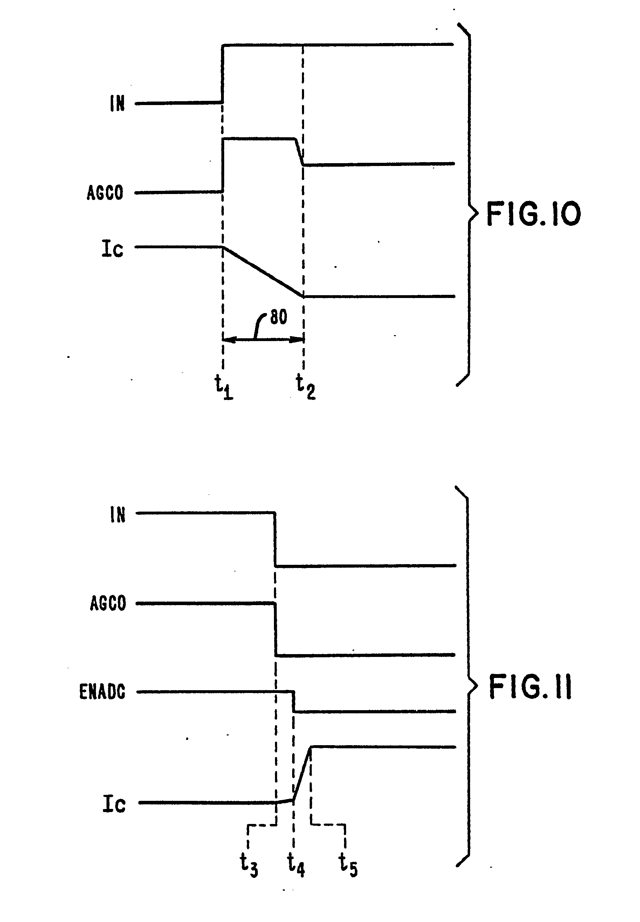

The operation of the automatic gain control circuit 10 will now be described in more detail with particular reference to Figs. 10-15, which illustrate the input and output signals for the automatic gain control circuit 10 under various input conditions, and the behavior of the control current $I_c$. In Figs. 10-15 it should be understood that the time plots illustrated for the input and output signals represent signal levels in decibels rather than the actual analog waveforms.

For ease of explanation, there will first be described the data behavior of the automatic gain control circuit 10, that is to say, the condition when data signals are being received on the input lead 12. In the data phase the signal ENADC is high, producing a slow decay operation; the signal RLS is also high thereby enabling the noise hit protection circuit 44, and the signals PRDIS is low. The input is amplified by an amount to provide an output signal AGCO whose level is close to that required. When at a given instant the output signal AGCO is too high the automatic gain control circuit 10 performs an attack operation in response to the level detector 30 providing a high level signal AD. When the signal AD is high the attack/decay control circuit 36 provides a ground level output signal as described above to cause the control current $I_c$ provided by the control current generator 48 to decrease in an exponential manner. This decrease causes a reduction in gain in the variable gain amplifier 14 and a reduction in the level of the output signal AGCO from the output amplifier 20. When the signal AGCO becomes lower than the reference potential $V_{ref}$, the signal AD changes to a low level and the output signal of the attack/decay control circuit 36 becomes an open-circuit (floating). As described above this causes the control current generator 48 to cause to control current $I_c$ to increase exponentially until the level of the signal AGCO again exceeds the voltage reference level $V_{ref}$, the signal AD becomes high again causing a repetition of the above-described operation.

Referring now to Fig. 10, there is illustrated the behaviour of the automatic gain control circuit 10 in response to a transition on the input lead 12 from a state when no signal is received to a state wherein a signal is received. The top plot in Fig. 10 represents (as a signal level) the signal IN on the input lead 12. When no signal is present, the amplification of the variable gain amplifier 14 is at a maximum, as determined by the control current $I_c$ which is also at a maximum. Howerer, since no signal is present the output signal AGCO is at a zero level.

At time $t_1$ it is assumed that a signal is received on the input lead 12. Since the control current $I_c$ is at a maximum value the output signal AGCO rises to a maximum level. This causes a high level signal AD and introduces an attack operation during the time period $t_1$ to $t_2$ as shown by reference 80. At time $t_2$ it is assumed that the control current has fallen to a nominal level in accordance with the input signal level, the output signal AGCO of the automatic gain control circuit 10 also becoming a nominal level.

It should be understood that prior to the reception of a data input signal on the lead 12 the microprocessor controlled signal RLS is at a low level thereby disabling operation of the noise hit protection circuit 44.

Following the just-described attack operation the signal RLS will be set to high thereby enabling the noise hit protection circuit 44.

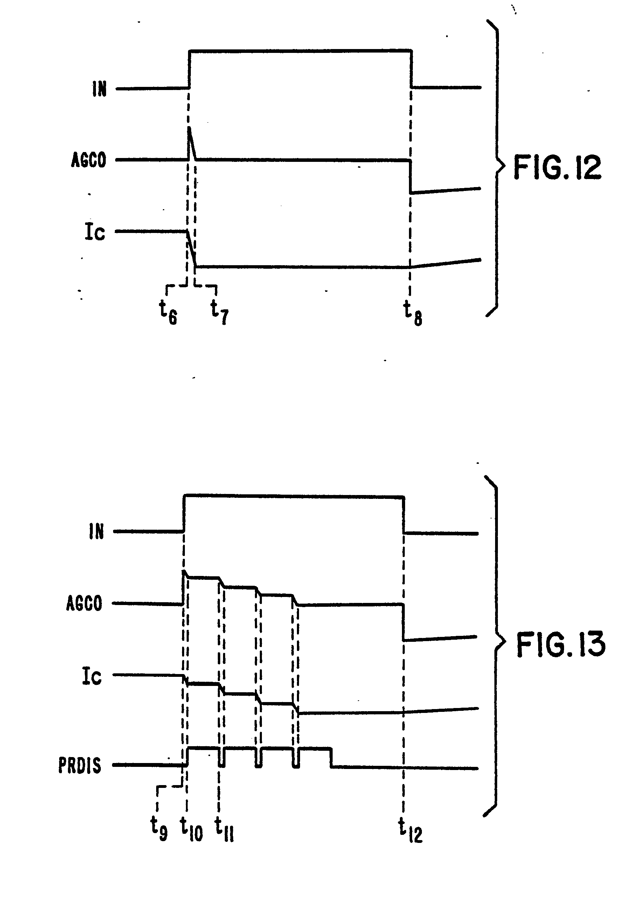

The behavior of the automatic gain control circuit 10 in response to the termination of a data input signal at the end of a data phase operation will now be described with reference to Fig. 11. At time $t_3$ the input signal IN terminates and substantially simultaneously the output signal AGCO falls rapidly to zero. The output signal AD of the level detector 30 therefore goes low and the attack/decay control circuit 36 causes the control current generator 48 to become an open-circuit thereby causing a slow decay operation since the control current $I_c$ increases relatively slowly. At time $t_4$ the receiver detects that line input signals are no longer present and microprocessor control causes the signal ENADC to change from high to low thereby causing the attack/decay circuit output ADCO to become a —5V level which initiates a fast decay operation wherein the control signal $I_c$ is caused to increase more rapidly until the time $t_5$.

Operation in response to a sudden change in signal level, referred to as a gain hit, during the data phase will now be described. Referring to Fig. 12, operation when the noise hit protection circuit 44 is disabled by a low level signal RLS will first be described. At time $t_6$ it is assumed that a gain hit of 2 dB occurs. As is seen in Fig. 12 the input level increase is followed initially by an increase in the output signal AGCO. Howerer, this increase causes the level detector 30 to provide a high level signal AD thereby causing to attack/decay control circuit 36 to initiate an attack operation by providing a ground level ADCO signal to the control current generator 48. This causes an attack operation in which the control current $I_c$ decreases rapidly until time $t_7$ when the signal LDS on the line 24 becomes equal to the reference voltage $V_{ref}$. At the time $t_7$ the signal AGCO will have reverted to its nominal level. When the gain hit terminates at time $t_8$ a slow decay operation takes place as is seen from the slowly rising level of the control current $I_c$ after time $t_8$.

There will now be considered the effect of a gain hit when the signal RLS is high, whereby the noise hit protection circuit 44 is enabled. At time $t_9$ an attack operation is initiated as has just been described. Howerer, after approximately 50 µs (50 microseconds) at time $t_{10}$ the noise hit protection circuit 44 causes signal PRDIS to go high thereby inhibiting the attack operation. The signal PRDIS remains high for about 10 msec (10 milliseconds) until time $t_{11}$ after which a further attack operation is enabled for a further period of 50 µs. It will be appreciated that the output level AGCO reverts to its nominal level in steps which in the present embodiment are steps of 0.5 dB. The total attack time is about 40 ms opposed to 200 µs in the situation described above when the noise protection circuit 44 is disabled. It is found in practice that this lengthened attack operation does not adversely affect the performance of the modem receiver in which the automatic gain control circuit 10 is utilized. When the gain hit terminates at time $t_{12}$ a slow decay operation takes place as before.

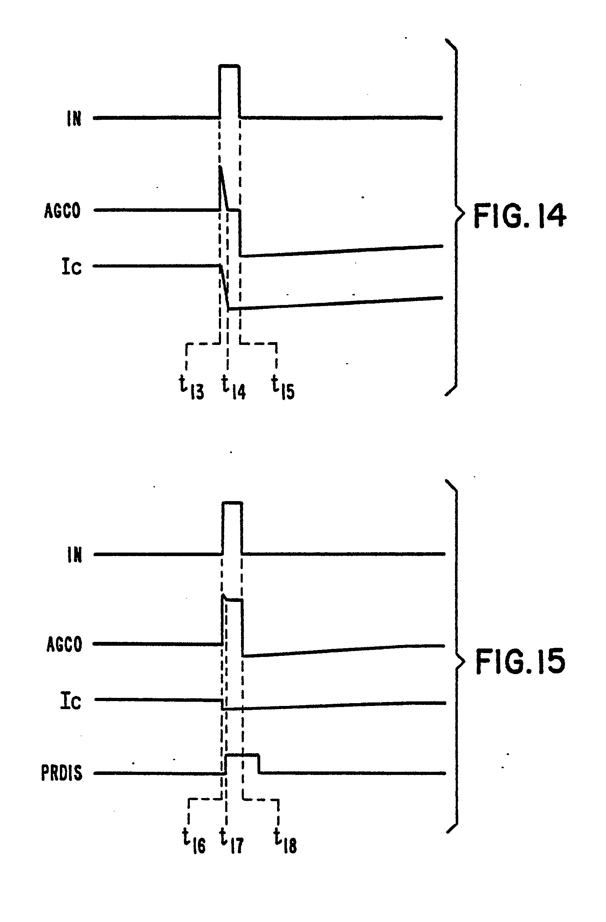

The behavior of the automatic gain control circuit 10 in the data phase when a noise hit occurs will now be considered. A noise hit may be considered as a high amplitude noise pulse having a relatively short duration, e.g. a few milliseconds. To clarify the effect of the operation of the noise hit protection circuit 44 the behavior of the automatic gain control circuit 10 will first be considered where no noise hit protection circuit 44 is provided. Assume that noise hit of, say 6 dB above the input data signal level occurs for about 5 ms from time $t_{13}$. The noise pulse is illustrated on the input signal IN at the top of Fig. 14. The response of the circuit is similar to that described with reference to Fig. 12. Thus, an attack operation takes place rapidly, at about 10 dB/msec during the time interval $t_{13}$ to $t_{14}$. At time $t_{15}$ when the noise impulse terminates, the output signal AGCO drops to about 6 dB below its nominal level and a slow decay operation then takes place. During this decay, and particularly initially after time $t_{15}$, the output signal AGCO will be at a low level and it is found that such low level may cause errors in a modem receiver in which the signal AGCO is utilized in that the modem will loose synchronization.

Referring now to Fig. 15, operation in the data phase in response to a noise hit which occurs when the noise hit protection circuit 44 is enabled by a high level signal RLS will now be described. Assuming the same noise hit amplitude of a 6 dB and duration of 5 msec, initially at time $t_{16}$, the signal AGCO will rise by 6 dB causing an attack operation, in the manner previously described. Howerer, after about 50 μs, at time $t_{17}$, when the signal AGCO has decreased by about 0.5 dB, the signal PRDIS will become high, as was described hereinabove with reference to Fig. 6. The high level signal PRDIS will last for about 10 msec, inhibiting any further attack operation for such period. In fact, as was described above, a slow decay operation will take place but because of the slow nature of such decay operation, the AGCO level may be regarded as approximately constant for a few milliseconds. During the occurrence of the high level PRDIS signal, it is assumed that at time $t_{18}$ the noise hit signal terminates. Initially, the signal AGCO will follow the input level drop of about 6 dB resulting in an AGCO level of about 0.5 dB below its nominal level. Such relatively small reduction in the AGCO level below its nominal level is found not to adversely affect synchronization in a modem receiver utilizing the signal AGCO. Thus synchronization will be maintained even though erroneous data may be detected as a result of the hit.

Thus it will be appreciated that the noise hit protection circuit 44 ensures that the AGCO level output drops by only about 0.5 dB as compared with a drop of about 6 dB without the noise hit protection circuit. It should be noted that a larger amplitude noise pulse will cause an even greater drop in the level of the signal AGCO where the noise protection circuit 44 is not provided. Howerer with the noise protection circuit 44 effective the signal level drop will still be only about 0.5 dB. Normally, a noise pulse is of shorter duration than 10 msec. Howerer, if a noise pulse should last for longer than 10 msec then the signal AGCO will be caused to adjust its output level by 0.5 dB for every 10 ms that the noise impulse lasts. Howerer a considerable advantage is nevertheless achieved than if no noise hit protection circuit 44 were provided.

## Claims

1. An automatic gain control circuit including variable gain amplifying means (14, 20) adapted to amplify an input signal, control signal generator means (36, 48) adapted to generate a control signal ($I_c$) for controlling the gain of said variable gain amplifying means (14, 20), and level detection means (30) coupled to an output of said variable gain amplifying means (14, 20) and to an input of said control signal generator means wherein said level detection means (30) is adapted to provide a first or a second logic signal to said control signal generator means (36, 48) according to whether the output signal of said variable gain amplifying means is greater or less than a predetermined level, said first and second logic signals causing said control signal generator means (36, 48) to vary said control signal ($I_c$) in respective first and second directions so as to respectively reduce and increase the gain of said variable gain amplifying means (14, 20), characterized by protection means (44) coupled to said level detection means (30) and adapted whenever said first logic signal is provided for longer than a first predetermined time period ($t_{10}$ - $t_9$, or $t_{17}$ - $t_{16}$), to cause said control signal generator means (36, 48) to present said control signal ($I_c$) from varying in said first direction for a second predetermined time period ($t_{11}$ - $t_{10}$, or $t_{18}$ - $t_{17}$), thereby inhibiting any reduction in gain of said variable gain amplifying means (14, 20) during said second predetermined time period ($t_{11}$ - $t_{10}$, or $t_{18}$ - $t_{17}$).

2. An automatic gain control circuit according to claim 1, characterized in that said variable gain amplifying means (14, 20) includes an operational transconductance amplifier (50) and in that said control signal generator means (36, 48) includes a control current generator (48) adapted to provide said control signal ($I_c$) in the form of a control current varying in said first and second directions in an exponential manner.

3. An automatic gain control circuit according to claim 2, characterized in that the reduction in gain of said variable gain amplifying means (14, 20) produced by said first logic signal is effected at a relatively high rate and in that the increase in gain of said variable gain amplifying means (14, 20) produced by said second logic signal is effected at a relatively low rate.

4. An automatic gain control circuit according to claim 3, characterized in that said protection means (44) is adapted to provide a protection signal (PRDIS) whenever said first logic signal is provided for longer than said first predetermined time period, said protection signal (PRDIS) being effective to cause said control current generator (48) to provide said control signal ($I_c$) varying in said second direction for said second predetermined time period.

5. An automatic gain control circuit according to claim 1, characterized in that said protection means (44) is selectively operable under the control of a protection enabling signal (RLS).

6. An automatic gain control circuit according to claim 3, characterized in that said control signal generator means (36, 48) is selectively operable in response to a speed control signal (ENADC) to cause the increase in gain in said variable gain amplifying means (14, 20) to change from said relatively low rate to a higher rate.

7. An automatic gain control circuit according to claim 6, characterized in that said variable gain amplifying means (14, 20) includes an output amplifier (54) having an input coupled to an output of said operational transconductance amplifier (50) and adapted to provide first and second output signals (LDS, AGCO) representing respective first and second predetermined multiples of the output signal provided by said operational transconductance amplifier (50), said first output signal (LDS) geing applied to said level detection means (30) and said second output signal (AGCO) forming the output of said automatic gain control circuit (10).

8. An automatic gain control circuit according to claim 7, characterized in that said second output signal (AGCO) is fed back to provide d.c. offset compensation for said operational transconductance amplifier (50).

9. An automatic gain control circuit according to claim 4, characterized in that said protection means (44) includes a capacitor (C4) having a discharge path including switching means (68) having control inputs operable respectively by said first logic signal and by protection signal.

10. An automatic gain control circuit according to claim 9, characterized in that said control signal generator means (36, 48) includes control switching means (62, 64) coupled to a control input on said control current generator (48), said control current generator (48) including an operational amplifier (76) having an input coupled to said control input and to a further capacitor (C5) and having an output coupled to the base of a transistor (78) having its emitter-collector path coupled to said further capacitor (C5) and adapted to provide said control current ($I_c$).

### Patentansprüche

1. Automatische Verstärkungsregelungsschaltung mit Verstärkervorrichtungen (14, 20) mit veränderbarer Verstärkung, die geeignet sind, ein Eingangssignal zu verstärken, Steuersignalgeneratorvorrichtungen (36, 48), die geeignet sind, ein Steuersignal ($I_c$) zum Steuern der Verstärkung der Verstärkervorrichtungen (14, 20) mit veränderbarer Verstärkung zu erzeugen und einer Pegeldetektorvorrichtung (30), die mit einem Ausgang der Verstärkervorrichtungen (14, 20) mit veränderbarer Verstärkung und mit einem Eingang der Steuersignalgeneratorvorrichtungen gekoppelt ist, wobei die Pegeldetektorvorrichtung (30) geeignet ist, ein erstes oder ein zweites logisches Signal an die Steuersignalgeneratorvorrichtungen (36, 48) abhängig davon anzulegen, ob das Ausgangssignal der Verstärkervorrichtungen mit veränderbarer Verstärkung grösser oder kleiner als ein vorbestimmter Pegel ist, wobei das erste und zweite logische Signal bewirkt, dass die Steuersignalgeneratorvorrichtungen (36, 48) das Steuersignal ($I_c$) bezüglich einer ersten und zweiten Richtung verändern, um die Verstärkung der Verstärkervorrichtungen (14, 20) mit veränderbarer Verstärkung entsprechend zu reduzieren und zu erhöhen, gekennzeichnet durch eine Schutzvorrichtung (44), die mit der Pegeldetektorvorrichtung (30) gekoppelt und geeignet ist, wenn immer das erste logische Signal für länger als eine erste vorbestimmte Zeitperiode ($t_{10}$ - $t_9$, oder $t_{17}$ - $t_{16}$) abgegeben wird, dass die Steuersignalgeneratorvorrichtungen (36, 48) verhindern, dass das Steuersignal ($I_c$) sich für eine zweite vorbestimmte Zeitperiode ($t_{11}$ - $t_{10}$, oder $t_{18}$ - $t_{17}$) in der ersten Richtung ändert, wodurch eine Reduzierung der Verstärkung der Verstärkervorrichtungen (14, 20) mit veränderbarer Verstärkung während der zweiten vorbestimmten Zeitperiode ($t_{11}$ - $t_{10}$, oder $t_{18}$ - $t_{17}$) verhindert wird.

2. Automatische Verstärkungsregelungsschaltung nach Anspruch 1, dadurch gekennzeichnet, dass die Verstärkervorrichtungen (14, 20) mit veränderbarer Verstärkung einen Steilheits-Operationsverstärker (50) aufweisen und dass die Steuersignalgeneratorvorrichtungen (36, 48) einen Steuerstromgenerator (48) aufweisen, der geeignet ist, das Steuersignal ($I_c$) in Form eines Steuerstromes abzugeben, der exponentiell in der ersten und zweiten Richtung sich ändert.

3. Automatische Verstärkungsregelungsschaltung nach Anspruch 2, dadurch gekennzeichnet, dass die Verstärkungsreduzierung der Verstärkervorrichtungen (14, 20) mit veränderbarer Verstärkung, wie sie durch das erste logische Signal hervorgerufen wird, bewirkt wird mit einer verhältnismässig hohen Geschwindigkeit, und dass der Verstärkungsanstieg der Verstärkervorrichtungen (14, 20) mit veränderbarer Verstärkung, wie er durch das zweite logische Signal hervorgerufen wird, mit einer verhältnismässig niederen Geschwindigkeit bewirkt wird.

4. Automatische Verstärkungsregelungsschaltung nach Anspruch 3, dadurch gekennzeichnet, dass die Schutzvorrichtung (44) geeignet ist, ein Schutzsignal (PRDIS) immer dann abzugeben, wenn das erste logische Signal für eine Zeit abgegeben wird, die länger als die erste vorbestimmte Zeitperiode ist, wobei das Schutzsignal (PRDIS) bewirkt, dass der Steuerstromgenerator (48) das Steuersignal ($I_c$) für die zweite vorbestimmte Zeitperiode in der zweiten Richtung variierend abgegeben wird.

5. Automatische Verstärkungsregelungsschaltung nach Anspruch 1, dadurch gekennzeichnet, dass die Schutzvorrichtung (44) selektiv unter Steuerung eines Schutzbefähigungssignals (RLS) aktivierbar ist.

6. Automatische Verstärkungsregelungsschaltung nach Anspruch 3, dadurch gekennzeichnet, dass die Steuersignalgeneratorvorrichtungen (36, 48) selektiv betreibbar sind unter Ansprechen auf ein Geschwindigkeitssteuersignal (ENADC), um zu bewirken, dass sich der Verstärkungsanstieg in den Verstärkervorrichtungen (14, 20) mit veränderbarer Verstärkung von einer verhältnismässig niedrigen zu einer hohen Geschwindigkeit ändert.

7. Automatische Verstärkungsregelungsschaltung nach Anspruch 6, dadurch gekennzeichnet, dass die Verstärkervorrichtungen (14, 20) mit veränderbarer Verstärkung einen Ausgangsverstärker (54) aufweisen, der einen Eingang an einen Ausgang des Steilheit-Operationsverstärkers (50) gekoppelt hat und geeignet ist, erste und zweite Ausgangssignale (LDS, ACGO) abzugeben, die entsprechende erste und zweite vorbestimmte Vielfache des Ausgangssignals darstellen, das vom Steilheit-Operationsverstärker (50) abgegeben wird, wobei das erste Ausgangssignal (LDS) an die Pegeldetektorvorrichtung (30) angelegt wird und das zweite Ausgangssignal (ACGO) das Ausgangssignal der automatischen Verstärkungsregelungsschaltung (10) bildet.

8. Automatische Verstärkungsregelungsschaltung nach Anspruch 7, dadurch gekennzeichnet, dass das zweite Ausgangssignal (ACGO) zurückgeführt wird, um eine Gleichspannungsversetzungskompensation für den Steilheit-Operationsverstärker (50) zu bilden.

9. Automatische Verstärkungsregelungsschaltung nach Anspruch 4, dadurch gekennzeichnet, dass die Schutzvorrichtung (44) einen Kondensator (C4) aufweist, dessen Entladungsweg eine Schaltvorrichtung (68) besitzt, die Steuereingänge aufweist, die entsprechend durch das erste logische Signal und das Schutzsignal aktivierbar sind.

10. Automatische Verstärkungsregelungsschaltung nach Anspruch 9, dadurch gekennzeichnet, dass die Steuersignalgeneratorvorrichtungen (36, 48) Steuerschaltvorrichtungen (62, 64) aufweisen, die mit einem Steuereingang an dem Steuerstromgenerator (48) gekoppelt sind, wobei der Steuerstromgenerator (48) einen Operationsverstärker (76) aufweist, der einen Eingang mit dem Steuereingang und mit einem weiteren Kondensator (C5) gekoppelt hat und der einen Ausgang mit der Basis eines Transistors (78) gekoppelt hat, dessen Emitter-Kollektorstrecke mit dem weiteren Kondensator (C5) gekoppelt ist und geeignet ist, den Steuerstrom ($I_c$) abzugeben.

**Revendications**

1. Circuit de commande automatique de gain comprenant des moyens d'amplification (14, 20) à gain variable conçus pour amplifier un signal d'entrée, des moyens générateurs (36, 48) d'un signal de commande conçus pour générer un signal de commande ($I_c$) destiné à commander le gain desdits moyens (14, 20) d'amplification à gain variable, et des moyens (30) de détection de niveau couplés à une sortie desdits moyens (14, 20) d'amplification à gain variable et à une entrée desdits moyens générateurs de signal de commande, lesdits moyens (30) de détection de niveau étant conçus pour appliquer un premier ou un second signal logique auxdits moyens générateurs (36, 48) de signal de commande selon que le signal de sortie desdits moyens d'amplification à gain variable est supérieur ou inférieur à un niveau prédéterminé, lesdits premier et second signaux logiques agissant sur lesdits moyens (36, 48) générateurs de signal de commande pour qu'ils fassent varier ledit signal de commande ($I_c$) dans des première et seconde directions respectives afin de réduire et augmenter respectivement le gain desdits moyens d'amplification (14, 20) à gain variable, caractérisé par des moyens de protection (44) couplés auxdits moyens (30) de détection de niveau et destinés, lorsque ledit premier signal logique est produit au-delà d'une première période de temps prédéterminée ($t_{10}$-$t_9$, ou $t_{17}$-$t_{16}$), à agir sur lesdits moyens (36, 48) générateurs de signal de commande pour empêcher ledit signal de commande ($I_c$) de varier dans ladite première direction pendant une seconde période de temps prédéterminée ($t_{11}$-$t_{10}$ ou $t_{18}$-$t_{17}$), inhibant ainsi toute réduction de gain desdits moyens (14, 20) d'amplification à gain variable pendant ladite seconde période de temps prédéterminée ($t_{11}$-$t_{10}$ ou $t_{18}$-$t_{17}$)

2. Circuit de commande automatique de gain selon la revendication 1, caractérisé en ce que lesdits moyens d'amplification (14, 20) à gain variable comprennent un amplificateur opérationnel (50) à conductance de transfert et en ce que lesdits moyens générateurs (36, 48) de signal de commande comprennent un générateur (48) de courant de commande destiné à produire ledit signal de commande ($I_c$) sous la forme d'un courant de commande variant dans lesdites première et seconde directions d'une manière exponentielle.

3. Circuit de commande automatique de gain selon la revendication 2, caractérisé en ce que la réduction du gain desdits moyens d'amplification (14, 20) à gain variable, produite par ledit premier signal logique, s'effectue à une vitesse relativement élevée et en ce que l'augmentation du gain desdits moyens d'amplification (14, 20) à gain variable, produite par ledit second signal logique, s'effectue à une vitesse relativement basse.

4. Circuit de commande automatique de gain selon la revendication 3, caractérisé en ce que lesdits moyens de protection (44) sont conçus pour produire un signal de protection (PRDIS) lorsque ledit premier signal logique est produit au-delà de ladite première période de temps prédéterminée, ledit signal de protection (PRDIS) ayant pour effet d'agir sur le générateur (48) de courant de commande pour qu'il fasse varier ledit signal de commande ($I_c$) dans ladite seconde direction pendant ladite seconde période de temps prédéterminée.

5. Circuit de commande automatique de gain selon la revendication 1, caractérisé en ce que lesdits moyens de protection (44) peuvent être mis en œuvre sélectivement sous la commande d'un signal de validation de protection (RLS).

6. Circuit de commande automatique de gain selon la revendication 3, caractérisé en ce que lesdits moyens générateurs (36, 48) de signal de commande peuvent être mis en œuvre sélectivement en réponse à un signal de commande de vitesse (ENADC) pour faire passer de ladite vitesse relativement basse à une vitesse plus élevée l'augmentation de gain desdits moyens d'amplification (14, 20) à gain variable.

7. Circuit de commande automatique de gain selon la revendication 6, caractérisé en ce que lesdits moyens d'amplification (14, 20) à gain variable comprennent un amplificateur de sortie (54) ayant une entrée couplée à une sortie dudit amplificateur opérationnel (50) à conductance de transfert et destinée à produire des premier et second signaux de sortie (LDS, ACGO) représentant des premier et second multiples prédéterminés respectifs du signal de sortie produit par ledit amplificateur opérationnel (50) à conductance de transfert, ledit premier signal de sortie (LDS) étant appliqué auxdits moyens (30) de détection de niveau et ledit second signal de sortie (ACGO) formant la sortie dudit circuit (10) de commande automatique de gain.

8. Circuit de commande automatique de gain selon la revendication 7, caractérisé en ce que ledit second signal de sortie (ACGO) est renvoyé pour produire une compensation de décalage de courant continu pour ledit amplificateur opérationnel (50) à conductance de transfert.

9. Circuit de commande automatique de gain selon la revendication 4, caractérisé en ce que lesdits moyens de protection (44) comprennent un condensateur (C4) présentant un trajet de décharge comprenant des moyens de commutation (68) qui présentent des entrées de commande pouvant être actionnées respectivement par ledit premier signal logique et ledit signal de protection.

10. Circuit de commande automatique de gain selon la revendication 9, caractérisé en ce que lesdits moyens générateurs (36, 48) de signal de commande comprennent des moyens (62, 64) de commutation de commande couplés à une entrée de commande dudit générateur (48) de courant de commande, ledit générateur (48) de courant de commande comprenant un amplificateur opérationnel (76) ayant une entrée couplée à ladite entrée de commande et à un autre condensateur (C5) et ayant une sortie couplée à la base d'un transistor (78) dont le circuit émetteur-collecteur est couplé audit autre condensateur (C5) et est destiné à produire ledit courant de commande ($I_c$).

FIG. I

**FIG. 2**

**FIG. 3**

# FIG. 4

# FIG. 5

# FIG.6

# FIG.7

FIG.9

130μA

Ic

GAIN

Ic

0·65μA

8 sec

46dB

GAIN

0dB

0

FIG.8

130μA

Ic

GAIN

Ic

0·65μA

4m sec

46dB

GAIN

0dB

0

FIG.10

FIG.11

FIG.12

FIG.13

FIG. 14

FIG. 15